## Europäisches Patentamt
## European Patent Office
## Office européen des brevets

(19)

(11) Numéro de publication: **0 075 504**
**B1**

(12)

# FASCICULE DE BREVET EUROPEEN

(45) Date de publication du fascicule du brevet: **29.01.86**

(51) Int. Cl.⁴: **H 01 J 37/30**

(21) Numéro de dépôt: **82401634.9**

(22) Date de dépôt: **07.09.82**

(54) **Dispositif de limitation angulaire dans un système à faisceau de particules chargées.**

(30) Priorité: **22.09.81 FR 8117846**

(43) Date de publication de la demande:
**30.03.83 Bulletin 83/13**

(45) Mention de la délivrance du brevet:
**29.01.86 Bulletin 86/05**

(84) Etats contractants désignés:
**DE GB NL**

(56) Documents cités:
**EP-A-0 013 738**
**FR-A-2 351 497**
**GB-A-1 544 222**

**ELECTRONICS INTERNATIONAL, vol. 50, no. 10, mai 1977, pages 89-98, New York (USA); T.H.P. CHANG et al.: "Electron-beam lithography draws a finer line".**

(73) Titulaire: **THOMSON-CSF**
**173, Boulevard Haussmann**
**F-75379 Paris Cedex 08 (FR)**

(72) Inventeur: **de Chambost, Emmanuel**
**THOMSON-CSF SCPI 173, bld Haussmann**
**F-75379 Paris Cedex 08 (FR)**
Inventeur: **Trotel, Jacques**
**THOMSON-CSF SCPI 173, bld Haussmann**
**F-75379 Paris Cedex 08 (FR)**

(74) Mandataire: **Lepercque, Jean et al**
**THOMSON-CSF SCPI 173, Bld Haussmann**
**F-75379 Paris Cedex 08 (FR)**

Courier Press, Leamington Spa, England.

## Description

La présente invention se rapporte à un dispositif de limitation angulaire dans un système à faisceau de particules chargées à forme definié.

La présente invention concerne un système à faisceau de particules chargées conçu pour être utilisé dans la fabrication de configurations de circuits intégrés à grande échelle.

L'expression "particules chargées" utilisée jusqu'à présent désigne des électrons et des ions.

Dans la description qui va suivre, l'invention est décrite comme utilisant un faisceau d'électrons mais bien entendu cela n'a aucun caractère limitatif.

Les colonnes de faisceau d'électrons ont été largement développées pour être utilisées dans des systèmes permettant la fabrication de (micro)circuits semi-conducteurs intégrés à grande échelle. Ces colonnes sont particulièrement utiles pour l'écriture de configurations sélectonnées sur des pastilles semi-conductrices.

La fonction de ces systèmes est de tracer une configuration donnée sur une zone donnée avec une densité de charge spécifiée et une résolution marginale appropriée et ce, le plus rapidement possible.

Au vu des exigences indiquées ci-dessus, divers, systèmes lithographiques à faisceau d'électrons ont été conçus et utilisés. Le système à faisceau d'électrons classique utilisé pour la fabrication de (micro)-circuits intégrés peut comprendre une source de faisceau d'électrons, des lentilles de condensation, des étages d'alignement, des étages à lentilles de réduction, une lentille de projection, une unité de déflexion et une zone cible, le tout agencé d'une manière bien connue.

Les systèmes à faisceaux d'électrons par rapport aux systèmes de lithographie à photons présentent, du fait de leur longueur d'onde beaucoup plus faible, l'avantage d'une diffraction plus faible et donc permettent de s'affranchir des aberrations dues à la diffraction.

Un exemple de système lithographique à faisceau d'électrons est décrit dans le brevet FR—A—2 351 497.

Ce brevet a pour objet un dispositif permettant le tracé programmé de figures de formes différentes. Le dispositif comporte une source générant le faisceau de particules et une système d'optique électronique comprenant deux ensembles respectivement associés à deux stencils. Le premier ensemble forme l'image, à un grandissement fixe, du premier stencil sur le deuxième stencil. Un premier système de déflexion, à commande électrique, permet de déplacer cette image dans le plan du deuxième stencil. Le deuxième ensemble forme du stencil composite ainsi défini une image dans un plan objet. Un deuxième système de déflexion permet de déplacer cette dernière image dans le plan objet. Ce dispositif comprend en plus une lentille électronique supplémentaire formant l'image de la section la plus étroite du faisceau de particules généré par la source dans un plan déterminé dudit système d'optique électronique.

Mais la qualité de tels systèmes ne dépend pas seulement de la longueur d'onde des électrons mais aussi des aberrations dont ils peuvent souffrir. Ces aberrations peuvent exister pour un certain nombre de raisons, ce peut être notamment des aberrations mécaniques dues à des défauts de symétrie dans la fabrication des pièces mécaniques. Elles peuvent être aussi des aberrations géométriques dues à la géométrie même du système, sont par exemple, l'aberration sphérique liée au fait que les lentilles magnétiques sont plus convergentes à la périphérie qu'en leur centre. Cette aberration sphérique est proportionnelle au cube de l'ouverture angulaire.

Et enfin, dans les systèmes où le courant d'électrons est très fort, il peut exister des aberrations de nature coulombienne d'autant plus grandes que le courant de faisceau électrique est grand. Il peut s'agir de phénomès de charge d'espace ou d'interactions entre deux électrons survenant à l'intérieur du faisceau ou de champ électriques parasites provenant de charges électroniques accumulées sur des isolants qui peuvent être, par exemple, des couches minces condensées qui contaminent des matériaux conducteurs.

Le dispositif de l'invention présente l'avantage de limiter le courant de faisceau dès le début du parcours électronique, et donc permet une réduction maximale des effets de charge électrique. Ce dispositif permet en outre la simplification mécanique du système en remplaçant plusieurs diaphragmes par un seul, et la simplification de la procèdure d'alignement du faisceau électronique dans la colonne.

L'invention a pour objet un dispositif de limitation angulaire dans un système à faisceau de particules chargées à forme définie, ce système comprenant une source générant ce faisceau de particules et un système d'optique électronique comprenant des moyens de déflexion de ce faisceau et des moyens de délimitation de sa section suivant ladite forme définie qui permet la projection de l'image de cette section de faisceau sur un plan cible, un diaphragme unique de limitation angulaire du faisceau disposé entre la source et le système d'optique électronique, le courant utile du faisceau au niveau du plan cible étant supérieur au millième du courant émis par la source; ledit système comprenant au moins une lentille électronique supplémentaire formant l'image de la section la plus ètroite du faisceau de particulés généré par la source dans un plan déterminé dudit système d'optique électronique; la lentille supplémentaire étant disposée entre la source et le diaphragme, de manière à ce que ce diaphragme soit dans son plan focal.

L'invention sera mieux comprise au moyen de la description ci-après et des figures annexées parmi lesquelles:

— les figures 1 à 3 illustrent des dispositifs de l'art connu;
— la figure 4 illustre le dispositif de l'invention.

Dans le systèmes d'optique électronique utilisés pour focaliser un faisceau électronique sur un plan cible $P_4$, le faisceau électronique au niveau du plan cible $P_4$ est défini par sa section et son ouverture angulaire. Selon les systèmes, la section du faisceau est l'image de la source ou de stencils de formes diverses positionnés dans des plans conjugués du plan de l'échantillon.

L'ouverture du faisceau est limitée par des diaphragmes placés à une certaine distance des plans conjugés du plan de l'echantillon. L'intérêt de limiter l'ouverture α du faisceau est de réduire les aberrations géométriques prenant naissance dans l'objectif et dans le système de déviation du faisceau, parmi ces aberration, l'aberration sphérique est proportionnelle à $\alpha^3$, le coma à $\alpha^2$, la courbure de champ de l'astigmatisme à α.

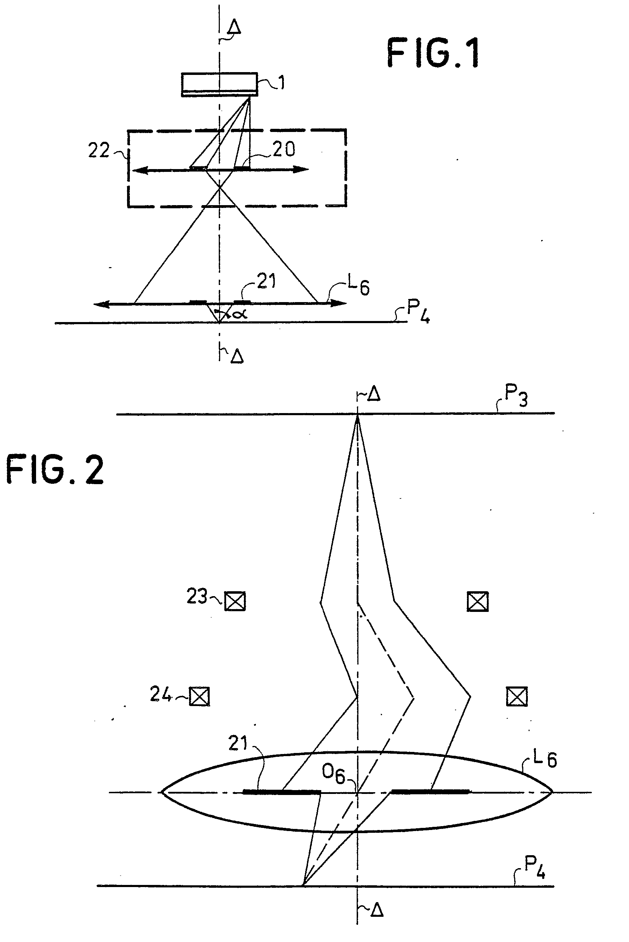

Sur la figure 1, le dispositif 22 permet la réduction avec un ou plusieurs lentilles de la section la plus étroite du faisceau d'électrons à la source 1 dite "crossover". Un diaphragme 20 limiteur de faisceau est disposé à l'intérieur de ce dispositif. La lentille $L_6$ est l'objectif qui permet la focalisation du faisceau sur le plan cible $P_4$. Le diaphragme 21 est le dernier diaphragme limiteur de faisceau, c'est la diaphragme prépondérant.

Ce diaphragme contrairement aux autres qui permettent les effets de charge d'espace en limitant l'intensité du faisceau, a pour de réduire les aberrations géométriques.

Ainsi lorsque plusieurs diaphragmes limitent l'ouverture angulaire d'un faisceau, un seul est prépondérant; à la figure 1 c'est le diaphragme 21. Les diaphragmes non prépondérants situés avant le diaphragme prépondérant sur le parcours électronique ont pour but de limiter le courant de faisceau avant le diaphragme prépondérant pour réduire les effets de charges électriques.

En ce qui concerne le diaphragme prépondérant 21, l'art connu consiste a le placer au centre optique $O_6$ de l'objectif $L_6$ dans le cas où une double déflexion fait pivoter le faisceau au centre optique $O_2$, comme ceci est représenté à la figure 2.

Ainsi la double déflexion du faisceau est réalisée par les deux déviateurs 23 et 24; $P_3$ représente le dernier plan conjugué du plan cible $P_4$.

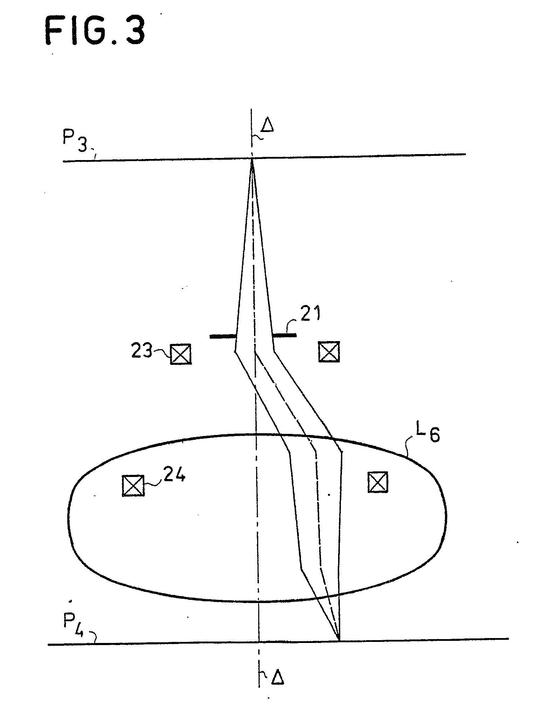

Dans le cas où le système de déviation n'astreint pas le faisceau à pivoter au centre optique, le dernier diaphragme qui est le diaphragme prépondérant 21 peut être positionné avant le déviateur comme représenté à la figure 3. $P_3$ représente le dernier plan conjugué du plan cible $P_4$. Dans ce cas lentille $L_6$ est généralement plus épaisse comme représenté sur cette figure 3.

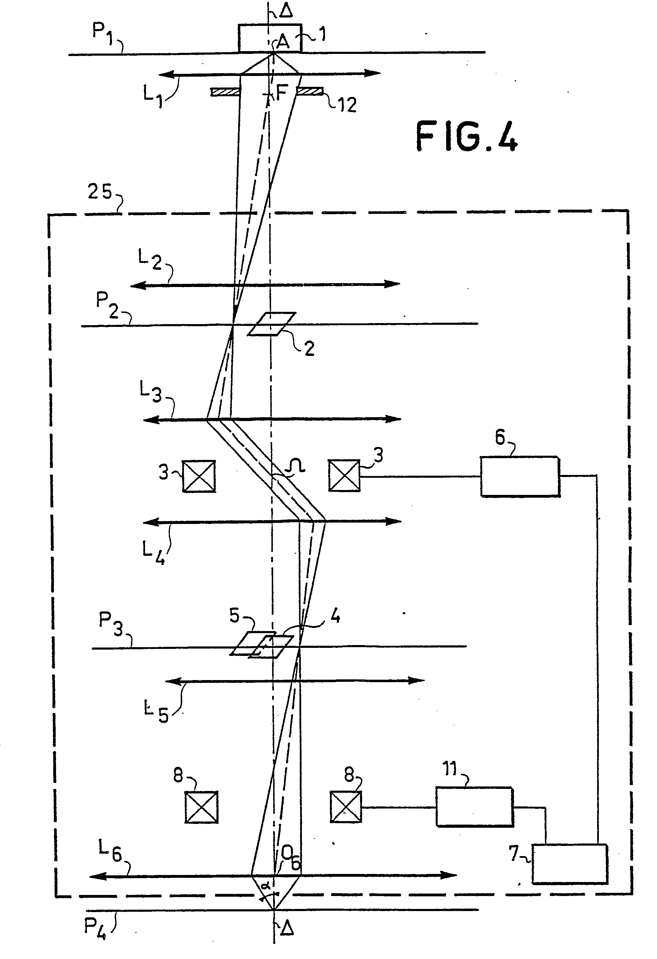

Un tel dispositif peut être illustré par l'article de CHANG et al publié dans la revue "Electronics International"' vol 50 (1977), pages 89—93, en se référant plus particulièrement à la figure 4(c).

Un diaphragme de limitation angulaire de faisceau ("Beam-Limiting Aperture) est disposé avant les organes de déflexion.

Le système de lithographie décrit comprend en outre des lentilles électroniques supplémentaires disposées entre la source d'électrons et ce diaphragme.

Il comprend également un stencil ("Round-Shaping Aperture") de forme fixe circulaire dont l'image est projetée sur le plan cible.

Dans les systèmes à faisceaux rectangulaires variables récemment développés an micro-lithographie ou dans tout système de faisceau à forme définie, il est possible de remplacer tous les diaphragmes de limitation d'ouverture angulaire par un seul diaphragme 12 situé entre la source 1 et le premier stencil 2 définissant la forme du faisceau au plan cible $P_4$ comme représenté à la figure 4.

Dans la pratique, ceci pourra être réalisé lorsque le rapport du courant électronique d'échantillon au courant émis par la source est suffisament grand, typiquement supérieur au 1/1000. Pour expliquer cette restriction, il faut considérer l'exemple d'un microscope électronique à balayage ou le courant émis par la source serait de l'ordre de 100 microampères et où un diaphragme situé sous la source devrait limiter le courant à une valeur inférieure au nanoampère, soit un rapport entre les deux courants inférieur à $10^{-5}$. Dans ce cas, le diamètre $d_f$ de la section du faisceau, quelques centimètres au dessous de la source, étant inférieur au millimètre, le diamètre $d_o$ de l'ouverture du diaphragme, vérifiant la relation $d_o=10^{-5} d_f$ qui rend compte du fait que le courant traversant un diaphragme est proportionnel à la section de l'ouverture dudit diaphragme, serait inférieur à 3 micromètres, et sa réalisation pourrait alors s'avérer suffisamment délicate pour écarter ce type de solution. Par contre, la réalisation d'un diaphragme dont le diamètre d'ouverture est de 30 micromètres fait partie de l'art connu, c'est pourquoi l'invention peut s'appliquer plus particulièrement aux systèmes où le rapport du courant utile au courant émis est supérieur à $10^{-3}$.

La figure 4 représente un système d'optique électronique pour faisceau rectangulaire comprenant un premier stencil 2 à ouverture de forme carrée dont l'image 5 est formée par les lentilles $L_3$ et $L_4$, au grossissement −1, sur le plan $P_3$ du deuxième stencil 4.

Un système déviateur 3 permet de déplacer l'image 5 par rapport au deuxième stencil à ouverture carrée 4. L'intersection de l'image 5 et du stencil 4 définit une section rectangulaire variable dont l'image réduite sera projetée sur un plan cible $P_4$ par une lentille objectif $L_6$. Un deuxième système déviateur 8 permet de positionner l'image composite des 2 stencils dans le plan $P_4$. Les éléments 6 et 11 représentent deux convertisseurs numérique-analogique qui permettent de commander les systèmes déviateurs 3 et 8. Ces deux convertisseurs sont connectés à la sortie d'un calculateur de commande 7.

La source 1 est par exemple une source thermo-ionique. La lentille $L_1$ projette l'image aggrandie de la section la plus étroite du faisceau à la source 1 dans le plan $P_2$ du stencil 2.

Le diaphragme 12 est situé dans le plan du foyer F de la lentille $L_1$, la lentille $L_2$ de faible convergence est réglée de façon à ce que le plan du diaphragme 12 soit conjugué avec le centre de déflexion $\Omega$ du déviateur 3. La lentille $L_5$, de faible convergence également, est réglée de façon à ce que le centre optique $O_6$ de la lentille $L_6$ soit conjuguée avec le point $\Omega$.

L'image du diaphragme 12 étant faite au centre optique $O_6$ de la lentille $L_6$ ledit diaphragme limite donc l'ouverture du faisceau au plan cible $P_4$ de la même façon que si l'on avait placé en $O_6$ un diaphragme de même dimension que l'image de 12. En outre, les points $\Omega$ et $O_6$ étant conjugés, lorsque le déviateur 3 est actionné par le système 6 pour modifier les dimensions du faisceau rectangulaire au plan $P_3$, la position du faisceau au centre optique $O_6$ reste invariante sur l'axe de la lentille.

Sur la figure 4, il a été représente également deux rayons issus d'un point A de la source, décentré par rapport à l'axe de symétrie $\Delta$, lesdits rayons s'appuyant sur les bords du diaphragme 12.

## Revendications

1. Dispositif de limitation angulaire dans un système à faisceau de particules chargées à forme définie, ce système comprenant une source (1) générant ce faisceau de particules et un système d'optique électronique (25) comprenant des moyens (3, 8) de déflexion de ce faisceau et des moyens de délimitation (2, 4) de sa section suivant ladite forme définie qui permet la projection de l'image de cette section de faisceau sur un plan cible ($P_4$), un diaphragme unique (12) de limitation angulaire du faisceau disposé entre la source (1) et le système d'optique électronique (25), le courant utile du faisceau au niveau du plan cible étant supérieur au millième du courant émis par la source (1); ledit système comprenant au moins une lentille électronique supplémentaire ($L_1$) formant l'image de la section la plus étroite (A) du faisceau de particules généré par la source (1) dans un plan ($P_2$) déterminé dudit système d'optique électronique (25); la lentille supplémentaire ($L_1$) étant disposée entre la source ($S_1$) et le diaphragme (12), de manière à ce que ce diaphragme soit dans son plan focal (F).

2. Dispositif selon la revendication 1, caractérisé en ce que le système d'optique électronique (25) comprend en outre une lentille objectif ($L_6$) qui focalise le faisceau sur le plan cible ($P_4$), le diaphragme unique (12) étant conjugué au centre optique de ladite lentille objectif.

3. Dispositif selon la revendication 1, caractérisé en ce que ce système d'optique électronique (25) comporte un premier plan objet ($P_2$) constituant ledit plan déterminé, dans lequel se trouve matérialisé un premier stencil (2), éliminant une partie du faisceau émis par ladite source (1), comportant un premier système optique électronique ($L_3$, $L_4$) formant de ce stencil (2), avec un grandissement prédéterminé une image réelle (5) dans un second plan objet ($P_3$), ledit second plan objet ($P_3$) contenant un deuxième stencil (4), ladite image réelle (5) et ledit stencil (4) formant un stencil fictif de ladite forme définie, des premiers moyens de déviation (3) à commande électrique étant interposés entre le premier ($P_2$) et le deuxième plan objet ($P_3$) de façon à déplacer de manière programmée ladite image réelle (5) dans ledit premier plan objet ($P_3$), et à faire varier ladite forme définie du stencil fictif, un deuxième système optique étant prévu pour former l'image réelle dudit diaphragme fictif sur le plan cible ($P_4$), des deuxièmes moyens de déviation (8) a commande électrique étant prévus pour déplacer sur ledit plan cible ($P_4$) ladite image réelle.

4. Dispositif selon la revendication 1, caractérisé en ce que le système à faisceau de particules chargées est un système de microlithographie par faisceau d'électrons.

## Patentansprüche

1. Vorrichtung zur Winkelbegrenzung in einem System mit einem Bündel aus geladenen Teilchen und von definierter Gestalt, wobei dieses System eine dieses Teilchenbündel erzeugende Quelle (1) und ein Elektronenoptiksystem (25) aufweist, das Mittel (3, 8) zur Ablenkung dieses Bündels und Mittel (2, 4) zur Begrenzung seines Querschnitts entsprechend der genannten definierten Gestalt umfaßt, wodurch das Bild dieses Bündelquerschnittes auf eine Zielebene ($P_4$) projiziert werden kann, mit einer einzigen Blende (12) zur Winkelbegrenzung des Bündels, welche zwischen der Quelle (1) und dem Elektronenoptiksystem (25) angeordnet, ist, wobei der Nutzstrom des Bündels auf der Höhe der Zielebene größer als ein Tausendstel des von der Quelle (1) abgegebenen Stromes ist; wobei das System ferner wenigstens eine zusätzliche elektronische Linse ($L_1$) umfaßt, die das Bild des kleinsten Querschnittes (A) des durch die Quelle (1) erzeugten Teilchenbündels in einer bestimmten Ebene ($P_2$) des Elektronenoptiksystems (25) erzeugt; wobei die zusätzliche Linse ($L_1$) zwischen der Quelle ($S_1$) und der Blende (12) derart angeordnet ist, daß diese Blende sich in ihrer Brennebene (F) befindet.

2. Vorrichtung nach Anspruch 1, dadurch gekennzeichnet, daß das Elektronenoptiksystem (25) ferner eine Objektivlinse ($L_6$) umfaßt, welche das Bündel auf die Zielebene ($P_4$) fokussiert, wobei die einzige Blende (12) mit dem optischen Zentrum der genannten Objektivlinse konjugiert ist.

3. Vorrichtung nach Anspruch 1, dadurch gekennzeichnet, daß das Elektronenoptiksystem (25) eine erste Objektebene ($P_2$) umfaßt, welche die genannte bestimmte Ebene bildet und in welcher eine erste Matrize (2) materialisiert ist, die einen Teil des von der Quelle (1) abgegebenen Bündels eliminiert, mit einem ersten elektronenoptischen System (L₃, L₄), welches diese Matrize (2) bildet, mit einer vorbestimmten Vergrößerung eines reellen Bildes (5) in einer zweiten Objektebene (P₃), wobei diese zweite Objektebene (P₃) eine zweite Matrize (4) enthält, wobei ferner das reelle Bild (5) und die genannte Matrize (4) eine fiktive Matrize der genannten definierten Gestalt bilden, und wobei erste Ablenkmittel (3) mit elektrischer Steuerung zwischen der ersten (P₂) und der zweiten (P₃) Objektebene derart angeordnet sind, daß das genannten reelle Bild (5) in programmierter Weise in der genannten ersten Objektebene (P₃) verschoben wird und die genannte definierte Gestalt der fiktiven Matrize verändert wird, wobei ferner ein zweites optisches System vorgesehen ist, um das reelle Bild der genannten fiktiven Blende in der Zeilebene (P₄) zu erzeugen, und wobei zweite Ablenkmittel (8) mit elektrischer Steuerung vorgesehen sind, um das genannte reelle Bild in der genannten Zielebene (P₄) zu verschieben.

4. Vorrichtung nach Anspruch 1, dadurch gekennzeichnet, daß das System mit geladenen Teilchen ein Elektronenstrahl-Mikrolithographie-System ist.

**Claims**

1. Device for angular limitation in a system comprising a beam of charged particles and of defined shape, said system comprising a source (1) generating said particle beam and an electron optical system (25) comprising means (3, 8) for deflecting said beam and means (2, 4) for limiting the cross-section thereof in accordance with said defined shape which permits projection of the image of said beam cross-section onto a target plane (P₄), a single diaphragm (12) for angular limitation of the beam disposed between the source (1) and the electron optical system (25), the useful flow of the beam at the level of the target plane being greater than one thousandth of the flow emitted by the source (1); said system comprises at least one additional electronic lens (L₁) forming the image of the smallest cross-section (A) of the particle beam generated by the source (1) in a predetermined plane (P₂) of the electron optical system (25); the additional lens (L₁) is disposed between the source (S₁) and the diaphragm (12) in such a manner that said diaphragm is disposed in its focal plane (F).

2. Device according to claim 1, characterized in that the electron optical system (25) further comprises an objective lens (L₆) which focuses the beam on the target plane (P₄), the single diaphragm (12) being conjugated with the optical centre of said objective lens.

3. Device according to claim 1, characterized in that the electron optical system (25) comprises a first object plane (P₂) forming said predetermined plane in which a first stencil (2) is materialized eliminating a portion of the beam furnished by the source (1), a first electron optical system (L₃, L₄) forming said stencil (2) with a predetermined magnification of a real image (5) in a second object plane (P₃), said second object plane (P₃) containing a second stencil (4), said real image (5) and said stencil (4) forming a fictive stencil of said defined shape, first deflection means (3) with electrical control being disposed between the first (P₂) and the second (P₃) object plane in such a manner that said real image (5) is displaced in programmed manner in said object plane (P₃) and said defined shape of the fictive stencil is varied, a second optical means being provided for forming the real image of said fictive diaphragm in the target plane (P₄) and second deflection means (8) with electrical control being provided to displace said real image in said target plane (P₄).

4. Device according to claim 1, characterized in that the charged particle beam system is an electron beam microlithography system.

# FIG.1

# FIG.2

# FIG.3

0 075 504

FIG.4